# DEMANDE DE BREVET EUROPEEN

(11) **EP 4 368 949 A1**
(43) Date de publication de la demande: **15.05.2024**
(21) Numéro de dépôt: 23208364.2
(22) Date de dépôt: 07.11.2023
(51) Int. Cl.: G01D 4/00, G01R 22/00, G01R 22/06, H04L 67/12

(54) **PROCEDE DE TRANSMISSION DE DONNEES SELON UN PROTOCOLE COMPRENANT UNE CLASSE D'OBJETS D'INTERFACE DE COMMUNICATION DE TYPE PORT-SERIE, ET DISPOSITIF ELECTRONIQUE EXECUTANT LEDIT PROCEDE**

(30) Priorité: 08.11.2022 FR 2211594
(71) Demandeur: Sagemcom Energy & Telecom SAS, 92270 Bois-Colombes (FR)
(72) Inventeur: TEBOULLE, Henri, 92270 BOIS-COLOMBES (FR); ROTER, Ziv, 92270 BOIS-COLOMBES (FR); ADAM, Sylvestre, 92270 BOIS-COLOMBES (FR)
(74) Mandataire: Cabinet Le Guen Maillet

(57) **Abrégé**

L'invention concerne un procédé de transmission de données depuis et vers un dispositif électronique (12) configuré pour opérer au moins des transmissions de données de comptage de consommation d'une grandeur physique, lesdites transmissions étant opérées par ledit dispositif électronique (12) selon au moins un protocole de communication de données (par exemple DLMS/COSEM) faisant référence à des données définies selon un modèle de données orienté objet, ledit modèle de données définissant une pluralité de classes d'objets d'interface de communication, permettant d'accéder à des éléments du dispositif électronique, ledit procédé étant tel que ledit modèle de données orienté objet comprend au moins une classe d'objets d'interface de communication (199) comprenant des attributs (A1, .., A9) et des méthodes (M1, .., M2) pour opérer des communications via un port de communication de type port série compris dans ledit dispositif électronique (12), ou connecté à celui-ci. L'invention concerne également un dispositif électronique (12) exécutant le procédé.

## Description

### DOMAINE TECHNIQUE

La présente invention se rapporte à un procédé de communication apte à opérer des transmissions de données définies selon un modèle de données orienté objet, depuis et vers un dispositif électronique configuré pour la collecte de données de consommation d'une grandeur physique. Au moins un mode de réalisation de l'invention concerne un procédé de transmission de données via un port série d'un compteur intelligent de consommation électrique.

### ETAT DE LA TECHNIQUE ANTERIEURE

Les compteurs récents de consommation d'électricité sont des dispositifs électroniques dits « intelligents » aptes à transmettre des données vers un serveur distant, par exemple un serveur de gestion de consommation, à travers des réseaux de communication variés, notamment pour des services de tarification et de collecte d'informations en lien avec une consommation d'électricité. Ces compteurs intelligents sont en outre configurés pour recevoir des données depuis un serveur distant. De telles informations reçues par un compteur intelligent sont notamment utiles à sa configuration, par exemple pour limiter la puissance maximale qui peut être délivrée à travers ce compteur intelligent, ou pour la commutation d'un contact électrique interne au compteur intelligent. Des protocoles de communication ont été définis pour communiquer avec un compteur de consommation électrique intelligent, en échangeant des messages (des transmissions de données) dont le format est indépendant de la configuration physique du ou des réseaux utilisés pour la transmission de ces messages. Parmi ces protocoles, le protocole dit « DLMS » (du sigle anglais « *Device Language Message Spécification* ») et le modèle protocolaire de données « COSEM » (de l'acronyme anglais « *Companion Spécification for Energy Metering*») sont utilisés pour des applications de comptage de consommation électrique, indépendantes du support de communication, en s'appuyant notamment sur un principe *client-serveur* selon lequel un compteur intelligent opère comme serveur de données. Selon ce principe, un compteur intelligent de consommation électrique est dit « serveur COSEM » et est modélisé par un ensemble de dispositifs logiques, implémenté dans un dispositif électronique physique qu'est le compteur intelligent. Selon le protocole DLMS/COSEM, un dispositif logique d'un serveur COSEM est un ensemble d'objets d'interface de communication COSEM qui modélisent chacun différentes fonctions du compteur physique et qui sont accessibles par un dispositif dit « client » connecté au compteur intelligent opérant comme « serveur » via un réseau de communication, par l'intermédiaire d'interfaces de communications du compteur intelligent. Un tel objet d'interface présente des « attributs » et des « méthodes » qui peuvent être invoqués pour communiquer avec un tel compteur intelligent. Une structure d'interface est définie et décrite de façon unique dans une classe d'interfaces (ou classe d'objets d'interface) de communication qui est spécifiée et normalisée selon le protocole.

Les attributs représentent les caractéristiques de l'objet, par exemple, de tels attributs peuvent être des paramètres de configuration d'une interface de communication (interface encore appelée usuellement « port »). Un attribut peut aussi être un registre d'un compteur intelligent contenant une valeur de puissance consommée pendant une période prédéterminée. Les méthodes telles que définies dans le protocole DLMS et selon le modèle de données orienté objet COSEM, permettent de manipuler un objet pour accéder aux valeurs de ses attributs, en lecture et/ou en écriture. En d'autres termes une méthode selon le protocole DLMS est une fonction d'accès en lecture ou en écriture à un attribut d'un objet tel que, par exemple, un objet d'interface de communication. Les classes d'objets d'interface de communication ainsi définies dans le protocole DLMS / COSEM, ou selon d'autres protocoles similaires, constituent des outils de communication qu'un fabricant d'équipements de comptage (ou plus largement d'équipements connectés à un réseau de distribution d'énergie), peut utiliser lors d'étapes de conception et pour prévoir des fonctionnalités disponibles à partir d'un compteur intelligent ou impliquant des transmissions de données via un tel compteur, ou encore à partir d'un équipement connecté à un réseau de distribution d'énergie. Il n'existe cependant pas de moyens d'opérer des communications entre un serveur distant ou un équipement quelconque distant et un port série asynchrone haut débit compris dans un compteur intelligent ou connecté à celui-ci, ce qui limite les applications et services susceptibles d'être déployés via les moyens de communications existant entre un tel serveur / équipement et un dispositif électronique opérant des fonctions de compteur intelligent, ou plus largement entre un tel serveur / équipement et un équipement distant connectés à un même réseau de distribution d'électricité. Or, un tel port série, par exemple de type RS422 ou RS-485, présente un bon compromis entre ses caractéristiques de vitesse de transmission, de fiabilité de transmission, et sa simplicité de mise en oeuvre (peu de câblage).

La situation peut être améliorée.

### EXPOSE DE L'INVENTION

L'invention a pour but de proposer un procédé de transmission de messages via un protocole DLMS pour assurer un service de bout-en-bout entre un fournisseur d'énergie ou un prestataire de services, d'une part, et un utilisateur final (un abonné du fournisseur et/ou du prestataire) d'autre part, le service utilisant un port série asynchrone haut débit chez l'abonné pour commander un ou plusieurs actuateurs et/ou collecter des informations depuis un ou plusieurs capteurs installés chez cet abonné.

A cet effet, il est proposé un procédé de transmission de données depuis et vers un dispositif électronique configuré pour opérer au moins des transmissions de données de comptage de consommation d'une grandeur physique, lesdites transmissions étant opérées par ledit dispositif électronique selon au moins un protocole de communication de données faisant référence à des données définies selon un modèle de données orienté objet, ledit modèle de données définissant une pluralité de classes d'objets d'interface de communication, chacune desdites classes d'objets définies selon ledit modèle comprenant un ensemble d'attributs représentatifs de caractéristiques d'un objet défini selon ladite classe, ainsi qu'un ensemble de méthodes permettant d'accéder à des valeurs desdits attributs, ledit procédé étant exécuté dans ledit dispositif électronique ou dans un serveur distant connecté audit dispositif électronique et étant caractérisé en ce que ledit modèle de données orienté objet comprend au moins une classe d'objets d'interface de communication comprenant des attributs et des méthodes pour opérer des communication via un port de communication de type port série compris dans ledit dispositif électronique ou connecté à celui-ci.

Le procédé selon l'invention peut également comporter les caractéristiques suivantes, considérées seules ou en combinaison :
- Le modèle de données orienté objet est un modèle COSEM dérivé du modèle COSEM (IEC 62056-6-2 : 2017).
- Le au moins un protocole de communication est un protocole DLMS de l'ensemble de protocole standardisé IEC 62056.
- La au moins une classe d'objets d'interface de communication comprend des attributs et des méthodes pour opérer des communications grâce à un port série de type asynchrone.
- Les attributs et les méthodes sont configurés pour opérer des communications avec un port série asynchrone défini selon un standard de communication dit RS-422 ou un standard de communication dit RS-485.
- L'ensemble de méthodes comprend une méthode d'obtention d'un nombre d'octets disponibles en lecture dans une mémoire tampon du port série, une méthode d'écriture d'une suite d'octets prédéterminée dans une mémoire tampon en émission du port série ou une méthode de lecture d'une suite d'octets disponibles dans une mémoire tampon en réception du port série.
- La au moins une classe d'objets d'interface de communication comprend des attributs et des méthodes pour opérer des communications avec un port série de type asynchrone. L'invention a également pour objet un dispositif électronique configuré pour opérer au moins des transmissions de données de comptage de consommation d'une grandeur physique, les transmissions étant opérées par le dispositif électronique selon au moins un protocole de communication de données faisant référence à des données définies selon un modèle de données orienté objet, le modèle de données définissant une pluralité de classes d'objets d'interface de communication, chacune des classes d'objets définies selon le modèle comprenant un ensemble d'attributs représentatifs de caractéristiques d'un objet défini selon ladite classe, ainsi qu'un ensemble de méthodes permettant d'accéder à des valeurs des attributs, le dispositif électronique étant tel que le modèle de données orienté objet comprend au moins une classe d'objets d'interface de communication comprenant des attributs et des méthodes pour opérer des communications avec un port série compris dans le dispositif électronique ou connecté à celui-ci.

Le dispositif électronique selon l'invention peut également comporter les caractéristiques suivantes, considérées seules ou en combinaison :
- Le dispositif est configuré pour utiliser un modèle de données orienté objet qui est un modèle COSEM dérivé du modèle COSEM (IEC 62056-6-2 : 2017).
- Le dispositif électronique est configuré pour utiliser au moins un protocole de communication DLMS de l'ensemble de protocole standardisé IEC 62056.
- Le dispositif électronique est configuré pour utiliser au moins une classe d'objets d'interface de communication comprenant des attributs et des méthodes pour opérer des communications avec un port série de type asynchrone, préférentiellement du type défini selon un standard de communication dit RS-422 ou un standard de communication dit RS-485.
- Le dispositif électronique est un compteur de consommation d'électricité ou une passerelle domestique configurée pour la connexion d'un compteur de consommation d'électricité à un réseau de communication par courants porteurs en ligne.

L'invention a également pour objet un système de communication comprenant au moins un dispositif électronique tel que précédemment décrit et un serveur distant, configurés pour être connectés l'un à l'autre via un réseau de communication.

Enfin, l'invention concerne un produit programme d'ordinateur comprenant des instructions de codes de programme pour exécuter les étapes du procédé précédemment décrit, lorsque ce programme est exécuté par un processeur d'un dispositif électronique tel que précité ou par un processeur d'un serveur distant configuré pour être connecté audit dispositif électronique, ainsi qu'un dispositif de stockage comprenant un tel programme.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement un réseau de communication comprenant un dispositif électronique configuré pour exécuter un protocole de transmission de données selon un mode de réalisation ;
[Fig. 2] illustre des éléments d'une classe d'objets d'interface de communication définie selon un protocole de communication exécuté dans le réseau de communication déjà illustré sur la Fig. 1, selon un mode de réalisation ;
[Fig. 3] est un ordinogramme illustrant des étapes d'un procédé de transmissions de données utilisant au moins un objet d'interface instancié en référence à la classe d'objets d'interface de communication représentée sur la Fig. 2 ;
[Fig. 4] est un diagramme illustrant une architecture interne d'un dispositif électronique, par exemple de type compteur intelligent, configuré pour exécuter un procédé de transmission de données selon un mode de réalisation ;
[Fig. 5] est un diagramme illustrant une architecture interne d'un serveur d'un fournisseur de services configuré pour exécuter un procédé de transmission de données selon un mode de réalisation ;
[Fig. 6] est une représentation temporelle de transmissions de données sous forme de messages entre un serveur et une installation domestique connectée à un compteur intelligent dans une application de contrôle à distance de la charge d'une batterie, utilisant un protocole de communication selon un mode de réalisation ; et,
[Fig. 7] est une représentation temporelle de transmission de données sous forme de messages entre un serveur et une installation domestique connectée à un compteur intelligent dans une application de contrôle à distance d'une alarme anti-intrusion, utilisant un protocole de communication selon un mode de réalisation.

### EXPOSE DETAILLE DE MODES DE REALISATION

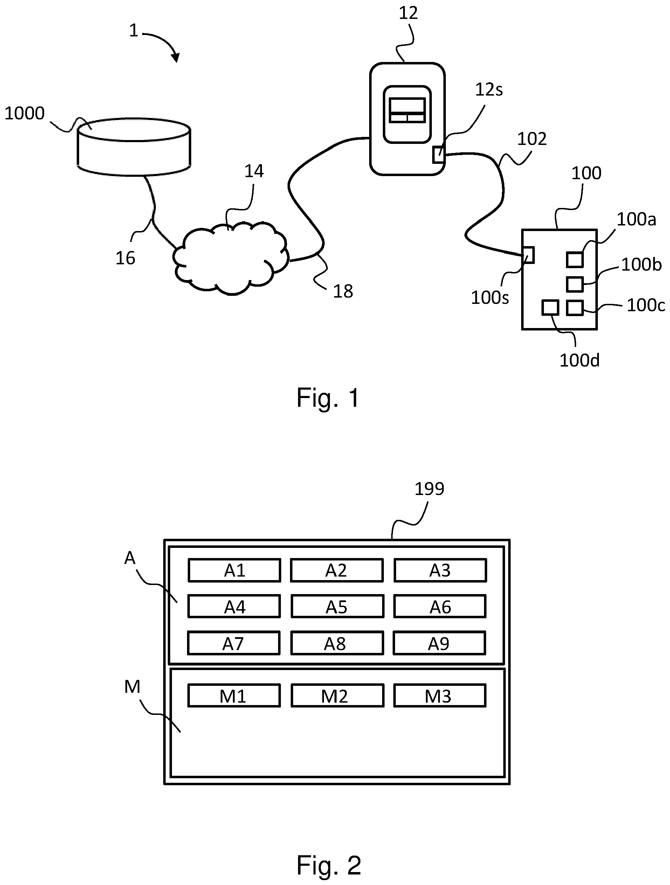

La Fig. 1 illustre schématiquement un réseau de communication 1 comprenant un réseau de communication par courants porteurs en ligne 14, auquel sont reliés un serveur 1000 d'un fournisseur de services ainsi qu'un dispositif électronique 12 configuré pour exécuter principalement des fonctions de compteur de consommation d'une grandeur physique (eau, électricité, gaz, etc.). Selon l'exemple décrit, le dispositif électronique 12 est un compteur de consommation électrique dit « intelligent », configuré notamment pour opérer des transmissions de données via le réseau de communication 14. Le serveur 1000 d'un fournisseur de services, encore appelé ici « serveur distant » est connecté au réseau de communication 14 via un lien d'interface 16. Le dispositif électronique 12, ici de type compteur intelligent de fourniture d'électricité, est connecté au réseau de communication 14 via un lien d'interface 18. Le dispositif électronique 12 comprend avantageusement un port série asynchrone 12s configuré pour relier une installation domestique 100 au dispositif électronique 12 via un lien de connexion série 102. Pour ce faire, l'installation domestique 100 comprend un port série asynchrone 100s qui peut être configuré pour opérer des communications avec le port série asynchrone 12s du dispositif électronique 12. Selon un mode de réalisation, les ports série 12s et 100s sont du type RS-422. Selon une variante de réalisation, les ports série 12s et 100s sont du type RS-485. L'installation domestique 100 est par exemple une installation domotique. Selon l'exemple de réalisation décrit, l'installation domestique 100 comprend une borne de recharge de batterie supervisée ainsi qu'une alarme anti-intrusion. Ces exemples ne sont pas limitatifs et l'installation domestique 100 peut comprendre, selon des variantes, une grande variété de dispositifs notamment de type capteurs ou actionneurs implémentés pour opérer des fonctions quelconques (surveillance de bien, sécurité des personnes, assistance, optimisation des consommations d'énergie, etc.). La borne de recharge de batterie de l'installation domestique 100 comprend un contrôleur 100a de charge de batterie et un relais de connexion de batterie 100b configuré pour autoriser ou pour interrompre la charge d'une batterie présente dans l'installation domestique 100. L'alarme anti-intrusion de l'installation domestique 100 comprend notamment un détecteur d'intrusion 100c et une sirène 100d.

Selon un mode de réalisation, le serveur distant 100 et le dispositif électronique 12 sont configurés pour pouvoir opérer des transmissions de données, par exemple des données de comptage de consommation d'une grandeur physique, selon au moins un protocole de communication de données faisant référence à des données définies selon un modèle de données orienté objet. En outre, le modèle de données utilisé définit une pluralité de classes d'objets d'interface de communication, et chacune de ces classes d'objets définies selon le modèle comprend un ensemble d'attributs représentatifs de caractéristiques d'un objet défini selon cette classe, ainsi qu'un ensemble de méthodes permettant d'accéder à des valeurs de ces attributs, en lecture et/ou en écriture.

Astucieusement et avantageusement, le procédé de communication utilisé exécuté dans le dispositif électronique 12 ou encore dans un serveur distant connecté au dispositif électronique 12, tel que le serveur distant 1000, comprend au moins une classe d'objets d'interface 199 de communication comprenant des attributs et des méthodes pour opérer des transmissions via un port de communication de type port série compris dans le dispositif électronique 12 ou connecté au dispositif électronique 12, tel que le port série 12s.

La Fig. 2 décrit la classe d'objets d'interface 199, qui peut être référencée via un identifiant unique *Class_Id* de classe d'objets d'interface dans un protocole de communication, et éventuellement via un numéro de version *Version_Id.* Avantageusement, la classe d'objets d'interface 199 comprend des attributs et des méthodes pour opérer des communications via un port de communication de type port série, asynchrone et à haut débit. La classe d'objets d'interface 199 comprend un ensemble A d'attributs et un ensemble M de méthodes. L'ensemble A d'attributs comprend des attributs A1, A2, A3, A4, A5, A6, A7, A8 et A9 utiles à la configuration d'un port série asynchrone à haut débit tel que le port série physique 12s du dispositif électronique 12. L'ensemble M de méthodes comprend des méthodes M1, M2 et M3 utiles à des transmissions de données depuis et vers un port série asynchrone à haut-débit tel que le port série 12s du dispositif électronique 12.

Selon l'exemple décrit, les attributs A1, A2, A3, A4, A5, A6, A7, A8 et A9 de l'ensemble d'attributs A de la classe d'objets d'interface 199 sont respectivement associés à des caractéristiques (paramètres de fonctionnement) d'une interface série asynchrone physique (encore appelée communément « port série ») telles que :
- L'attribut A1, de rang 1 dans la classe d'objets d'interface 199 détermine un nom logique *logical_name* d'un port série instancié à partir de cette classe, sous la forme d'une chaine de caractères alphanumériques ;
- L'attribut A2, de rang 2 dans les attributs de la classe d'objets d'interface 199 détermine une valeur *baudrate* de débit de transmission via un port série instancié à partir de cette classe ;
- L'attribut A3, de rang 3 dans les attributs de la classe d'objets d'interface 199 détermine un code *databits* définissant un nombre de bits de données utilisé pour le codage d'une donnée lors d'une transmission de données via un port série instancié à partir de cette classe ;
- L'attribut A4, de rang 4 dans les attributs de la classe d'objets d'interface 199 détermine un code *stopbits* définissant un nombre de bits de stop utilisés pour le codage d'une donnée lors d'une transmission de données via un port série instancié à partir de cette classe ;
- L'attribut A5, de rang 5 dans les attributs de la classe d'objets d'interface détermine un code *parity* définissant un mode de transmission avec bit(s) de parité ou sans bit de parité via un port série instancié à partir de cette classe ;
- L'attribut A6, de rang 6 dans les attributs de la classe d'objets d'interface 199 détermine un code *flowcontrol* définissant un mode de transmission avec ou sans contrôle de flux via un port série instancié à partir de cette classe ;
- L'attribut A7, de rang 7 dans les attributs de la classe d'objets d'interface 199 détermine une taille maximale *txtbuffer_size* de tampon mémoire (buffer) de transmission pour une transmission via un port série instancié à partir de cette classe ;
- L'attribut A8, de rang 8 dans les attributs de la classe d'objets d'interface 199 détermine un code *pending_byte* définissant un état de contenance (nombre d'octets disponibles, par exemple) d'une mémoire tampon buffer d'un port série instancié à partir de cette classe ;
- L'attribut A9, de rang 9 dans les attributs de la classe d'objet d'interface 199 détermine un état *flowcontrol_state* d'un mécanisme (ou circuit) de contrôle de flux de transmissions de données via un port série instancié à partir de cette classe.

Toujours selon l'exemple décrit, les méthodes M1, M2 et M3 de l'ensemble de méthodes B de la classe d'objets d'interface 199 sont respectivement associées à des fonctions (opérations de configuration ou de transmission de données) d'une interface série asynchrone (encore appelée communément « port série ») telles que :
- La méthode M1, de rang 1 dans les méthodes de la classe d'objets d'interface 199 opère une initialisation ou une réinitialisation *reset (data)* des attributs A1 à A9, des mémoires tampons en émission et en réception, ainsi que de tout ou partie des circuits de fonctionnement internes à un port série instancié à partir de cette classe, en affectant, le cas échéant des valeurs par défaut à des attributs ;
- La méthode M2, de rang 2 dans les méthodes de la classe d'objets d'interface 199 opère une transmission de données *send_bytes (data)* d'une chaîne de données *data* depuis un port série instancié à partir de cette classe vers un dispositif connecté à ce port série, via un dispositif électronique comprenant ledit port série ;
- La méthode M3, de rang 3 dans les méthodes de la classe d'objets d'interface 199 opère une transmission de données *receive_bytes (data)* d'une chaîne de données *data* depuis un port série d'un dispositif électronique, instancié à partir de cette classe, en provenance d'un dispositif connecté à ce port série.

Selon un mode de réalisation, les attributs du modèle de données orienté objet de la classe d'objets d'interface 199 sont définis tel que :
- l'attribut A1 est une chaîne de caractère d'une taille maximale prédéterminée ;
- l'attribut A2 peut prendre une valeur parmi les valeurs 0 à 10 correspondant respectivement à un débit de 300 bauds, 1200 bauds, 2400 bauds, 4800 bauds, 9600 bauds, 19200 bauds, 38400 bauds, 57600 bauds, 115200 bauds, 230400 bauds et 460800 bauds ;
- l'attribut A3 peut prendre une valeur parmi les valeurs 0 à 4 correspondant respectivement à 5 bits de donnée, 6 bits de donnée, 7 bits de donnée, 8 bits de donnée et 9 bits de donnée par mot de donnée ;
- l'attribut A4 peut prendre une valeur parmi les valeurs 1, 1.5 et 2, correspondant au nombre de bit(s) de stop positionnés en fin de mot de donnée ;
- l'attribut A5 peut prendre une valeur parmi les valeurs 0 à 4 correspondant respectivement à une absence de calcul de parité sur un mot de donnée dite « NO PARITY », à une parité de type pair dite « EVEN », à une parité de type impaire dite « ODD », à une parité de type dit « MARK » ou à une parité de type dit « SPACE » ;
- l'attribut A6 peut prendre une valeur parmi les valeurs 0 à 2 correspondant respectivement à une absence de contrôle de flux dite « No Flow Control », à un contrôle de flux matériel d'un type dit « RTS/CTS » de l'anglais « Ready To Send » et « Clear To Send » ou à un contrôle de flux logiciel d'un type dit « XON/XOFF » ;
- l'attribut A7 prend une valeur définissant une taille maximale de mémoire tampon (buffer) en émission ;
- l'attribut A8 prend la valeur d'un nombre de mots de données disponible en réception dans une mémoire tampon (buffer) en réception, et,
- l'attribut A9 prend une valeur parmi les valeurs 0 et 1 correspondant respectivement à un état disponible dit « clear » et à un état occupé dit « busy » du port série en émission.

Selon un mode de réalisation, les méthodes du modèle de données orienté objet de la classe d'objets d'interface 199 sont définies tel que :
- Un paramètre data égal à 0 de la méthode *reset (data)* M1 réinitialise les mémoires tampons (buffers) en émission et en réception du port série en les remplissant avec des valeurs nulles (0) de type entier ;
- La méthode M2 *send_bytes (data)* opère une émission d'une chaîne de caractères codés sous formes d'octets vers un port série instancié ;
- La méthode M3 *receive_bytes (data)* opère une réception de données sous la forme d'une chaîne de caractères avec pour paramètre un nombre *data* maximal de données qu'un client COSEM peut lire depuis un port série instancié d'un dispositif électronique comprenant ce port série.

La définition de la classe d'objets d'interface 199 telle que précitée permet avantageusement de piloter le port série 12s embarqué dans le dispositif électronique 12, depuis le serveur distant 1000, en utilisant le protocole de transmission de données DLMS et le modèle de données COSEM, ou un protocole équivalent utilisant la classe d'objets d'interface 199.

Selon un mode de réalisation, un dispositif comprenant un port série contrôlable à distance après une instanciation de la classe d'objets d'interface 199 comprend un circuit électronique (ou contrôleur) interne de type interpréteur de commandes, pour traduire des premières commandes en deuxièmes commandes et envoyer alors ces deuxièmes commandes via le port série physique vers des dispositifs de types actionneurs ou capteurs contrôlables. Par exemple, une suite d'octets envoyée par le serveur distant 1000 dans le buffer en émission d'un port série du dispositif électronique 12, en invoquant un objet port série défini et instancié selon la classe d'objets d'interface 199 est ensuite interprétée par le dispositif électronique 12 comme une commande d'initialisation d'actionneurs de l'installation domestique 100, et une ou plusieurs commandes en découlant sont adressées en conséquence depuis le dispositif électronique 12 à l'installation domestique 100.

Avantageusement et grâce au pilotage à distance du port série 12s du dispositif électronique 12 ainsi rendu possible, un fournisseur de services peut proposer des services à un abonné d'un service de fourniture d'énergie ou de fourniture de fluide (électricité, eau, gaz, etc.) disposant d'un compteur intelligent tel que le dispositif électronique 12. Selon l'exemple décrit, un fournisseur de services peut, par l'intermédiaire du serveur distant 1000, implémenter des applications contrôlant le port série 12s du dispositif électronique 12 de type compteur intelligent de consommation, et donc, conséquemment, contrôler tout ou partie d'une installation domestique (ou domotique) telle que l'installation domestique 100.

Astucieusement, et dans la mesure où un dispositif opérant en qualité de serveur COSEM n'adresse pas spontanément de données à un dispositif client COSEM, comme peut l'être le serveur distant 1000 exécutant des applications en vue de contrôler à distance l'installation domestique 100 à travers le réseau de communication 1 et le dispositif électronique 12, il est proposé ici de créer des objets dans la classe d'objets d'interface 159, permettant d'initier ou plus largement d'organiser des transmissions de données entre le serveur distant 1000 opérant par exemple comme un client COSEM, et l'installation domestique 100 via le dispositif électronique 12 et son port série 12s.

Un objet « MONITOR » est ici proposé et configuré pour lire un nombre d'octets en attente d'être lus dans un buffer (en réception) du port série 12s instancié à partir de la classe d'objets d'interface 199, et qui a comme attribut un seuil de déclenchement de la lecture, dès qu'un nombre minimal d'octets disponibles est atteint.

Un objet « PUSH Setup » est également proposé ici, et qui comprend une méthode nommée « PUSH », lequel objet « PUSH Setup » comprend une liste d'attributs « PUSH Object List » pointant sur des objets, par exemple des objets COSEM, qui doivent être envoyés à un client, par exemple un client COSEM, tel que le serveur 1000.

Ainsi, un dispositif logique port série instancié à partir de la classe d'objets d'interface 199 dans le dispositif électronique 12 permet à un fournisseur de service opérant à partir du serveur distant 1000 de lire des données référencées dans une zone mémoire tampon associée à la méthode PUSH d'une part, et d'écrire des données vers le port série 12s d'autre part.

Une lecture de données référencées dans le buffer de la méthode PUSH, par le serveur distant 1000, utilise la méthode M3 *receive_bytes* du port série instancié à partir de la classe d'objets d'interface 199.

De la même façon, une écriture de données vers le port série, par le serveur distant 1000, utilise la méthode M2 *send_bytes* du port série instancié à partir de la classe d'objets d'interface 199.

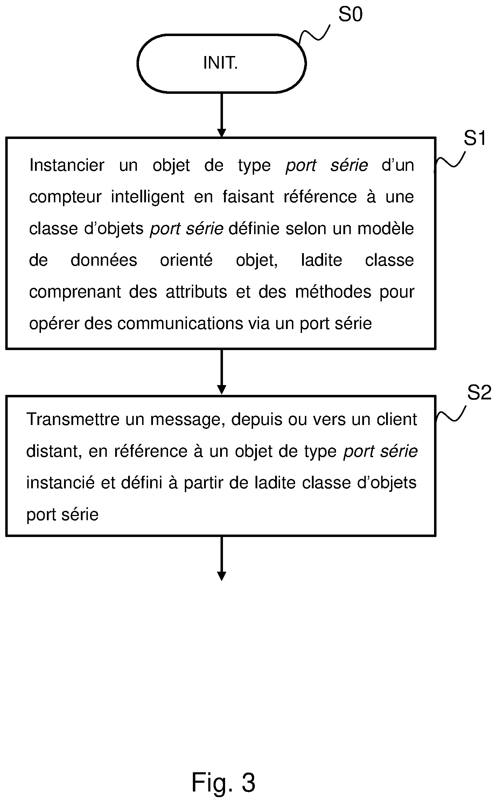

La Fig. 3 illustre des étapes d'un procédé de transmission de données permettant d'instancier un dispositif logique de type port série, par exemple de type RS-422 ou de type RS-485, pour contrôler un port série physique du même type du dispositif électronique 12 configuré pour opérer des transmissions de données avec le serveur distant 1000 en utilisant un protocole d'échange de données basé sur un modèle de données orienté objet. Selon l'exemple décrit, le serveur 1000 opère en tant que serveur d'applications d'un fournisseur de services et est configuré pour opérer des transmissions de données en utilisant un protocole DLMS / COSEM dit agnostique (c'est-à-dire opérant des transmissions de données sans considération aucune du format physique du ou des réseaux de communication utilisés). Toujours selon l'exemple décrit, le dispositif électronique 12 est lui aussi configuré pour opérer des transmissions de données en utilisant un protocole DLMS / COSEM dit agnostique. Le dispositif électronique 12 opère ici des fonctions de serveur de données DLMS / COSEM.

Une étape S0 correspond à une étape d'initialisation au terme de laquelle le serveur distant 1000 et le dispositif électronique 12 sont tous deux normalement configurés pour opérer des transmissions de données à travers le réseau de communication par courants porteurs en ligne 14, qui est en outre un réseau de distribution d'électricité.

Lors d'une étape S1, le dispositif électronique 12 détecte la présence du port série physique 12s, natif ou installé lors d'une opération de maintenance ou de mise à jour postérieure à sa mise en service, et instancie un objet de type port série logique tel que défini selon la classe d'objets d'interface 199, de sorte que cet objet logique puisse être adressé par l'intermédiaire des attributs et des méthodes définis selon un modèle de données orienté objet tel que le modèle de données COSEM, par un dispositif connecté au réseau de communication par courants porteurs en ligne 14. Le port série physique correspondant à cette instanciation peut alors être contrôlé par modification des attributs du port série logique instancié. Il est à noter qu'il peut exister autant de ports série logiques instanciés qu'il existe de ports série physiques dans le dispositif électronique 12 ou connectés à celui-ci.

Lors d'une étape S2 une transmission de données entre le serveur distant 1000 et le dispositif électronique 12 opère une lecture ou une écriture de données depuis ou vers le port série 12s, en invoquant une méthode de l'ensemble de méthodes M pour modifier des attributs de l'ensemble d'attributs A du port série logique instancié et autoriser en conséquence une configuration ou reconfiguration du port série 12s ou une transmission de données entre le serveur distant 1000 et le port série 12s du dispositif électronique 12 ou encore, le cas échéant, entre le port série 12s et l'installation domestique 100.

Bien évidemment, un port série logique instancié à partir de la classe d'objets d'interface 199 peut être adressé via un autre protocole d'échange de données que le protocole DLMS utilisant le modèle de données COSEM, dès lors que ce protocole est adapté pour effectuer des opérations sur un tel objet défini selon la classe d'objets d'interface 199.

Selon un mode de réalisation préféré, les échanges de données entre le serveur distant 1000 et le dispositif électronique 12 sont opérés selon un protocole DLMS/COSEM et le réseau de communications par courants porteurs en ligne opère selon un ensemble de protocoles de type G3-PLC.

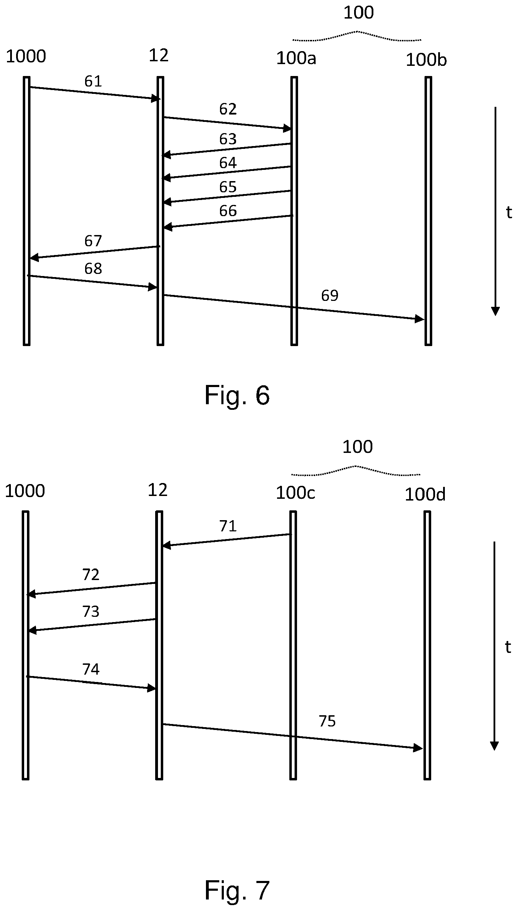

La Fig. 6 illustre schématiquement un séquencement d'opérations mis en oeuvre grâce à des transmissions de messages entre le serveur distant 1000, opérant comme un serveur d'applications d'un fournisseur de service(s) et l'installation domestique 100 avantageusement connectée au port série 12 du dispositif électronique 12. Selon l'exemple décrit en rapport avec la Fig. 6, l'installation domestique 100 est configurée pour opérer des fonctions de station (encore appelée borne) de charge de batterie grâce au contrôleur de charge 100a de batterie et au relais de connexion de batterie 100b. Selon l'exemple décrit ici, un fournisseur de services de charge à domicile de batterie, par exemple d'une batterie d'automobile électrique ou hybride, assure une surveillance et une gestion de la charge d'une batterie connectée à l'installation domestique 100. Par exemple, l'installation domestique 100 comprend une borne de recharge de véhicules électriques de type vélo, moto ou voiture.

Dans l'exemple développé ci-après, une transmission de données entre le serveur distant 1000 et le dispositif électronique 12, ou encore une transmission de données entre le dispositif 12 et l'installation domestique 100, via le port série 12s, le lien série 102 et le port série 100s, est nommée « message » et correspond à une transmission de données selon un premier protocole, de type DLMS/COSEM, entre le serveur distant 1000 et le dispositif électronique 12, et selon un deuxième protocole, propriétaire ou normalisé, entre le dispositif électronique 12 et l'installation domestique 100.

Une application de gestion de charge de batterie, exécutée dans le serveur distant 1000, envoie un message 61 au dispositif électronique 12, lequel message comprend une requête de lecture de registres de paramètres de fonctionnement du contrôleur de charge 100a. Les registres concernés contiennent des données renseignées par une unité de contrôle interne au contrôleur de charge 100a. Ces données sont une tension de charge V, un courant de charge I et une température Θ mesurée en un point d'une batterie en charge ainsi qu'un statut S de charge de batterie exprimé en pourcentage de charge. Cette requête est relayée par le dispositif 12, via son port série 12s, au contrôleur de charge 100a dans un message 62. Le contrôleur de charge 100a envoie alors, vers le port série 12s du dispositif électronique 12 des messages successifs 63, 64, 65 et 66 comprenant respectivement les valeurs de V, I, Θ et S. Le dispositif électronique 12 renvoie ses éléments dans un message 67 vers le serveur distant 1000. L'application de gestion de charge exécutée sur le serveur distant 1000 lit ses informations. Dans le cas illustré, la température Θ lue excède un seuil prédéterminé de température, dit « température Θs de sécurité » et le serveur 1000, sous contrôle de l'application de charge qu'il exécute, adresse un message 68 vers le dispositif électronique 12 comprenant une requête d'interruption de charge, laquelle requête est relayée par le dispositif électronique 12 via son port série 12s dans un message 69 adressé au relais de connexion de batterie 100b de l'installation domestique 100 afin d'opérer une déconnexion de la batterie subséquente à la détection d'une température Θ trop élevée de la batterie, laquelle température trop élevée est susceptible d'entraîner des dommages.

La Fig. 7 illustre schématiquement un autre séquencement d'opérations mis en oeuvre grâce à des transmissions de messages entre le serveur distant 1000, opérant là encore comme un serveur d'applications d'un fournisseur de services(s) et l'installation domestique 100 avantageusement connectée au port série 12s du dispositif électronique 12. Selon l'exemple décrit en rapport avec la Fig. 7, l'installation domestique 100 est configurée pour opérer des fonctions d'alarme anti-intrusion. Selon l'exemple décrit, un fournisseur d'un service de télésurveillance assure une surveillance à distance du logement ou du local dans lequel est située l'installation domestique 100 au moyen d'un détecteur d'intrusion 100c et permet notamment le déclenchement d'une sirène 100d selon un protocole prédéfini. Dans cet exemple encore, une transmission de données entre le serveur distant 1000 et le dispositif électronique 12, ou encore une transmission de données entre le dispositif 12 et l'installation domestique 100, via le port série 12s, le lien série 102 et le port série 100s, est nommée « message » et correspond à un message selon un premier protocole, de type DLMS/COSEM entre le serveur distant 1000 et le dispositif électronique 12, et selon un deuxième protocole, propriétaire ou normalisé, entre le dispositif électronique 12 et l'installation domestique 100.

Selon le séquencement décrit, le détecteur d'intrusion 100c est activé par l'effet d'une intrusion et adresse un message 71 au dispositif électronique 12 via son port série 12s, mentionnant qu'une information représentative d'un changement d'état du détecteur d'intrusion 100c est disponible. Le dispositif électronique 12 envoie alors au serveur distant 1000 exécutant une application de télésurveillance, une information notifiant le changement d'état du détecteur d'intrusion 100c, dans un message 72. Le serveur distant 100 lit alors l'état du détecteur d'intrusion 100c via un message 73 et adresse au dispositif électronique 12 un message 74 comprenant une requête d'activation de la sirène 100d, laquelle requête est relayée par le dispositif électronique 12 à la sirène 100d via un message 75. Parallèlement au déclenchement de la sirène 12d, le prestataire peut engager toute action utile à la protection du logement ou du local comprenant l'installation domestique 100.

Afin d'exécuter les procédés de transmission de données décrits, le serveur distant 1000 et le dispositif électronique 12 de type compteur intelligent comprennent chacun des circuits électroniques configurés pour implémenter notamment des fonctions d'unité de contrôle et d'interfaces de communications.

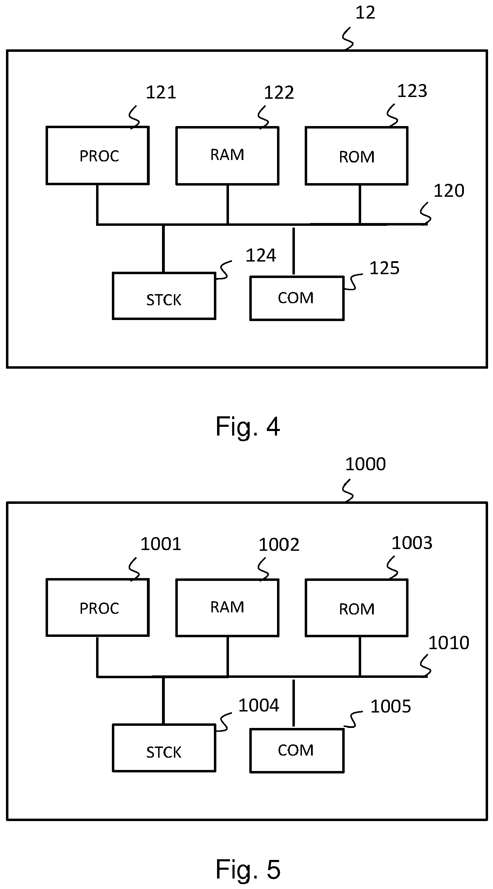

La Fig. 4 illustre schématiquement un exemple d'architecture interne du dispositif électronique 12, de type compteur intelligent. Selon l'exemple d'architecture matérielle représenté à la Fig. 4, le compteur intelligent 12 comprend alors, reliés par un bus de communication 120 : un processeur ou CPU (« Central Processing Unit » en anglais) 121 ; une mémoire vive RAM (« Random Access Memory » en anglais) 122 ; une mémoire morte ROM (« Read Only Memory » en anglais) 123 ; une unité de stockage telle qu'un disque dur (ou un lecteur de support de stockage, tel qu'un lecteur de cartes SD (« Secure Digital » en anglais) 124 ; au moins une interface de communication 125 permettant au compteur intelligent 12 de communiquer avec des dispositifs présents dans le réseau de communication 1 et comprenant le serveur distant 1000. L'interface de communication 125 comprend en outre le port série 12s.

Le processeur 121 est capable d'exécuter des instructions chargées dans la RAM 122 à partir de la ROM 123, d'une mémoire externe (non représentée), d'un support de stockage (tel qu'une carte SD), ou d'un réseau de communication. Lorsque le dispositif électronique de type compteur intelligent 12 est mis sous tension, le processeur 121 est capable de lire de la RAM 122 des instructions et de les exécuter. Ces instructions forment un programme d'ordinateur causant la mise en oeuvre, par le processeur 121, du procédé décrit en relation avec la Fig. 3, et plus largement d'un procédé de transfert de données tel qu'un protocole DLMS/COSEM, l'une de ses variantes ou un protocole équivalent.

Tout ou partie du procédé implémenté par le compteur intelligent 12, ou ses variantes décrites peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais). En général, le compteur intelligent 12 comprend de la circuiterie électronique configurée pour mettre en oeuvre le procédé décrit en relation avec lui-même ainsi qu'avec des dispositifs connectés au réseau de communication 1. Bien évidemment, le compteur intelligent 12 comprend en outre tous les éléments usuellement présents dans un système comprenant une unité de contrôle et ses périphériques, tels que, un circuit d'alimentation, un circuit de supervision d'alimentation, un ou plusieurs circuits d'horloge, un circuit de remise à zéro, des ports d'entrées-sorties, des entrées d'interruptions, des drivers de bus, cette liste étant non exhaustive.

La Fig. 5 illustre schématiquement un exemple d'architecture interne du serveur 1000, encore appelé ici serveur de gestion d'un fournisseur de service(s).

Selon l'exemple d'architecture matérielle représenté à la Fig. 5, le serveur 1000 comprend alors, reliés par un bus de communication 1010 : un processeur ou CPU (« Central Processing Unit » en anglais) 1001 ; une mémoire vive RAM (« Random Access Memory » en anglais) 1002 ; une mémoire morte ROM (« Read Only Memory » en anglais) 1003 ; une unité de stockage telle qu'un disque dur (ou un lecteur de support de stockage, tel qu'un lecteur de cartes SD (« Secure Digital » en anglais) 1004 ; au moins une interface de communication 1005 permettant au serveur 1000 de communiquer avec des dispositifs présents dans le réseau de communication 1 et comprenant en outre le dispositif électronique 12 et son port série 12s.

Le processeur 1001 est capable d'exécuter des instructions chargées dans la RAM 1002 à partir de la ROM 1003, d'une mémoire externe (non représentée), d'un support de stockage (tel qu'une carte SD), ou d'un réseau de communication. Lorsque le serveur 1000 est mis sous tension, le processeur 1001 est capable de lire de la RAM 1002 des instructions et de les exécuter. Ces instructions forment un programme d'ordinateur causant la mise en oeuvre, par le processeur 1001, du procédé décrit en relation avec la Fig. 3, et plus largement d'un procédé de transfert de données tel qu'un protocole DLMS/COSEM, l'une de ses variantes, ou encore un protocole équivalent.

Tout ou partie du procédé implémenté par le serveur 1000, ou ses variantes décrites peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais). En général, le serveur 1000 comprend de la circuiterie électronique configurée pour mettre en oeuvre le procédé décrit en relation avec lui-même ainsi qu'avec des dispositifs connectés au réseau de communication 1. Bien évidemment, le serveur 1000 comprend en outre tous les éléments usuellement présents dans un système comprenant une unité de contrôle et ses périphériques, tels que, un circuit d'alimentation, un circuit de supervision d'alimentation, un ou plusieurs circuits d'horloge, un circuit de remise à zéro, des ports d'entrées-sorties, des entrées d'interruptions, des drivers de bus, cette liste étant non exhaustive.

L'invention ne se limite pas aux seuls modes de réalisation et exemples précédemment décrits, mais concerne plus généralement un protocole de communication utilisant un modèle de données orienté objet et comprenant une classe d'objets d'interface définissant un port série notamment de type port série asynchrone haut-débit.

## Revendications

1. Procédé de transmission de données depuis et vers un dispositif électronique (12) configuré pour opérer au moins des transmissions de données de comptage de consommation d'une grandeur physique, ledit dispositif électronique (12) comprenant un circuit électronique interne de type interpréteur de commandes, lesdites transmissions étant opérées par ledit dispositif électronique (12) selon au moins un protocole de communication de données faisant référence à des données définies selon un modèle de données orienté objet, ledit modèle de données définissant une pluralité de classes d'objets d'interface de communication, chacune desdites classes d'objets définies selon ledit modèle comprenant un ensemble d'attributs (A) représentatifs de caractéristiques d'un objet défini selon ladite classe, ainsi qu'un ensemble de méthodes (M) permettant d'accéder en lecture et/ou en écriture à des valeurs desdits attributs, ledit procédé étant exécuté dans ledit dispositif électronique (12) ou dans un serveur distant (1000) connecté audit dispositif électronique (12) et étant **caractérisé en ce que** ledit modèle de données orienté objet comprend au moins une classe d'objets d'interface (199) de communication comprenant des attributs (A1, ..., A9) et des méthodes (M1, ..., M3) pour opérer des transmissions de données via un port de communication de type port série (12s) compris dans ledit dispositif électronique (12) ou connecté à celui-ci, et **en ce que** des premières commandes, reçues sous forme de suite d'octets dans une mémoire tampon en émission dudit port de communication de type port série, sont traduites par l'interpréteur de commandes en deuxièmes commandes et envoyées via ledit port de communication de type port série vers des dispositifs de types actionneurs ou capteurs.

2. Procédé de transmission de données selon la revendication 1, dans lequel ledit modèle de données orienté objet est un modèle COSEM dérivé du modèle COSEM selon la norme IEC 62056-6-2 : 2017.

3. Procédé de transmission de données selon la revendication 2, dans lequel ledit au moins un protocole de communication est un protocole DLMS de l'ensemble de protocoles standardisé selon la norme IEC 62056.

4. Procédé de transmission de données selon l'une quelconque des revendications précédentes dans lequel ladite au moins une classe d'objets d'interface (199) de communication comprend des attributs (A1, ..., A9) et des méthodes (M1, ..., M3) pour opérer des communications grâce à un port série de type asynchrone.

5. Procédé de transmission de données selon la revendication 4, dans lequel lesdits attributs et lesdites méthodes sont aptes à opérer des communications avec un port série asynchrone défini selon un standard de communication dit RS-422 ou un standard de communication dit RS-485.

6. Procédé de transmission de données selon l'une quelconque des revendications 1 à 5, dans lequel ledit ensemble de méthodes comprend une méthode d'obtention d'un nombre d'octets disponibles en lecture dans une mémoire tampon du port série, une méthode d'écriture d'une suite d'octets prédéterminée dans la mémoire tampon en émission du port série ou une méthode de lecture d'une suite d'octets disponible depuis une mémoire tampon en réception du port série.

7. Procédé de transmission de données selon l'une quelconque des revendications 1 à 6, dans lequel ladite au moins une classe d'objets d'interface (199) de communication comprend des attributs et des méthodes pour opérer des communications avec un port série de type asynchrone.

8. Dispositif électronique (12) configuré pour opérer au moins des transmissions de données de comptage de consommation d'une grandeur physique, ledit dispositif électronique (12) comprenant un circuit électronique interne de type interpréteur de commandes, lesdites transmissions étant opérées par ledit dispositif électronique (12) selon au moins un protocole de communication de données faisant référence à des données définies selon un modèle de données orienté objet, ledit modèle de données définissant une pluralité de classes d'objets d'interface de communication, chacune desdites classes d'objets définies selon ledit modèle comprenant un ensemble d'attributs (A) représentatifs de caractéristiques d'un objet défini selon ladite classe (199), ainsi qu'un ensemble de méthodes (M) permettant d'accéder en lecture et/ou en écriture à des valeurs desdits attributs (A), ledit dispositif électronique étant **caractérisé en ce que** ledit modèle de données orienté objet comprend au moins une classe d'objets d'interface de communication comprenant des attributs et des méthodes pour opérer des communications grâce à un port série compris dans ledit dispositif électronique ou connecté à celui-ci, et **en ce que** le circuit électronique interne de type interpréteur de commandes est configuré pour traduire des premières commandes, reçues sous forme de suite d'octets dans une mémoire tampon en émission du port de communication de type port série, en deuxièmes commandes, et pour envoyer les deuxièmes commandes via ledit port de communication de type port série vers des dispositifs de types actionneurs ou capteurs.

9. Dispositif électronique selon la revendication 8, dans lequel ledit modèle de données orienté objet est un modèle COSEM dérivé du modèle COSEM (IEC 62056-6-2 : 2017).

10. Dispositif électronique (12) selon la revendication 8, dans lequel ledit au moins un protocole de communication est un protocole DLMS de l'ensemble de protocole standardisé IEC 62056.

11. Dispositif électronique (12) selon l'une quelconque des revendications 8 à 10, dans lequel ladite au moins une classe d'objets d'interface de communication comprend des attributs et des méthodes pour opérer des communications via un port série de type asynchrone défini selon un standard de communication dit RS-422 ou un standard de communication dit RS-485.

12. Dispositif électronique (12) selon l'une des revendication 8 à 11, le dispositif électronique (12) étant un compteur de consommation d'électricité ou une passerelle domestique configurée pour la connexion d'un compteur de consommation d'électricité à un réseau de communication par courants porteurs en ligne.

13. Système de communication comprenant au moins un dispositif électronique (12) selon l'une des revendications 8 à 12 et un serveur distant (100) connectés via un réseau de communication (1).

14. Produit programme d'ordinateur **caractérisé en ce qu'**il comprend des instructions de codes de programme pour exécuter les étapes du procédé selon l'une quelconque des revendications 1 à 7, lorsque ledit programme est exécuté par un processeur dudit dispositif électronique (12) ou d'un serveur distant (1000) connecté audit dispositif électronique (12).

15. Support de stockage d'informations comprenant un produit programme d'ordinateur selon la revendication précédente.
